# EUROPEAN PATENT APPLICATION

(11) **EP 2 615 733 A1**
(43) Date of publication of application: **17.07.2013**
(21) Application number: 10856989.8
(22) Date of filing: 09.09.2010
(51) Int. Cl.: H02M 7/487

(54) **POWER SEMICONDUCTOR MODULE, POWER CONVERSION APPARATUS, AND RAILROAD VEHICLE**

(71) Applicant: Mitsubishi Electric Corporation, Tokyo 100-8310 (JP)
(72) Inventor: NAKASHIMA, Yukio, Tokyo 100-8310 (JP)
(74) Representative: Zech, Stefan Markus
(86) International application number: PCT/JP2010/065561
(87) International publication number: WO 2012/032642

(57) **Abstract**

In a power semiconductor module applied to a three-level power conversion apparatus for a railroad vehicle, switching elements 1 to 4 and clamp diodes 5 and 6 are respectively formed of a wide bandgap semiconductor, the switching element 1, the clamp diode 5, and the switching element 2 are arranged tandemly in this order on one side of an element substrate 82 along a flow direction of cooling air, the switching element 4, the clamp diode 6, and the switching element 3 are arranged tandemly in this order on the other side of the element substrate 82 along the flow direction of the cooling air, a temperature sensor 86A for external elements is arranged on an edge side of the element substrate 82 in a near-field region around the switching elements 1 and 4, a temperature sensor 86B for internal elements is arranged on an edge side of the element substrate 82 in a near-field region around the switching elements 2 and 3, and the switching elements 1 to 4, the clamp diodes 5 and 6, the temperature sensor 86A for external elements, and the temperature sensor 86B for internal elements are accommodated in one module.

## Description

### Field

The present invention relates to a power conversion apparatus that can be applied for, for example, a railroad vehicle, and more particularly to a power semiconductor module preferably used in this type of power conversion apparatus.

### Background

There are various types of power conversion apparatuses for a railroad vehicle. For example, in an application requiring power such as Shinkansen (bullet train), a three-level power conversion apparatus that operates at three voltage levels is frequently used. As a one-arm (one-leg) configuration connected to both terminals of a direct current (DC) voltage circuit having a neutral point, the three-level power conversion apparatus has such a configuration that four switching elements (first to fourth switching elements) in which diodes are connected in an anti-parallel configuration are connected in series, a connection point between the second and third switching elements are connected to a neutral point of a DC voltage source, each terminal of two serially connected clamp diodes is connected to a connection point between the first and second switching elements and a connection point between the third and fourth switching elements respectively, and a connection point between the two clamp diodes is connected to the neutral point of the DC voltage source (for example, Patent Literature 1).

In the three-level power conversion apparatus, an output current is relatively large, and the number of switching in the entire power conversion apparatus increases, and thus an amount of heat generation of the entire switching elements increases. Therefore, in the three-level power conversion apparatus, a configuration having a high cooling capacity using a method referred to as "ebullient cooling" is frequently used, in which cooling is performed by using as a coolant, for example, perfluorocarbon (commonly referred to as "Fluorinert"), which is one of alternatives for chlorofluorocarbon.

### Citation List

### Patent Literature

Patent Literature 1: Japanese Patent Application Laid-open No. 10-210759

### Summary

### Technical Problem

However, recently, there is a trend toward regulating chlorofluorocarbon as well as alternatives for chlorofluorocarbon because these substances largely affect on the environment. There has been a consensus on tightening of regulations on these substances particularly in Europe, and in the future, it can be assumed a situation that power conversion apparatuses using alternatives for chlorofluorocarbon cannot be used at all. As an alternative to the ebullient cooling using the alternatives for chlorofluorocarbon, a heat pipe apparatus using pure water and a heat sink having only a simple heat radiation mechanism have been considered.

Furthermore, as a recent technological trend, a semiconductor using SiC (silicon carbide) as a base (hereinafter, "SiC semiconductor") that is a highly pressure resistant and low-loss element and can operate in a high current, a high temperature, and a high frequency is attracting attention. When the power conversion apparatus is configured by using the SiC semiconductor, particularly, an operation in a high temperature is possible, and thus it is an excellent material for simplifying the configuration of a cooler. Therefore, in view of simplifying the cooler, the use of the SiC semiconductor attracts attention.

However, when the SiC semiconductor is applied to a high-output power conversion apparatus such as the three-level power conversion apparatus, application has not been so easy. It is because when the power conversion apparatus is used for a railroad vehicle, the amount of heat generation of each switching element becomes largely different according to an operation mode unique to the railroad vehicle, that is, in a case of power running in which a motor is driven to accelerate the railroad vehicle, and in a case of regeneration in which the motor is regeneratively operated to decelerate the railroad vehicle, and a temperature gradient on a mounting surface of the switching elements increases significantly.

When the ebullient cooler is used, the temperature gradient on the mounting surface of the respective switching elements decreases due to a strong cooling function, and thus over temperature control by an over temperature sensor becomes easy.

Meanwhile, when a simple heat radiation mechanism such as the heat sink is adopted, temperature distribution on the mounting surface of the switching elements becomes different according to the operation mode of the power conversion apparatus. Therefore, a new device is required for the over temperature control. However, the operation mode of the power conversion apparatus is determined according to various operating conditions and operation environments, and cannot be controlled by the apparatus side. Therefore, it is difficult to estimate the temperature distribution on the mounting surface of the switching elements accurately in a short time. Furthermore, when the SiC semiconductor is used, because an operation at a higher temperature than that of conventional cases can be performed, the amount of heat generation becomes extremely large, and this feature should be also taken into consideration. Accordingly, when the SiC semiconductor is used as the switching elements of the three-level power conversion apparatus and a simple heat radiation mechanism is adopted, it is not sufficient to apply the conventional method simply, and a disclosure of a new element arrangement including the elements and a temperature sensor is required.

The present invention has been achieved to solve the above problems, and an object of the present invention is to provide a power semiconductor module preferably used in a three-level power conversion apparatus in which a cooler is simplified.

It is also an object of the present invention to provide a power conversion apparatus including the power semiconductor module described above and a railroad vehicle including the power conversion apparatus.

### Solution to Problem

In order to solve the aforementioned problems, a power semiconductor module that is applied to a three-level power conversion apparatus for a railroad vehicle is configured to include: first and second switching elements that are connected serially in this order between a high-potential-side DC terminal and an AC terminal and on-off controlled to operate; third and fourth switching elements that are connected serially in this order between the AC terminal and a low-potential-side DC terminal and on-off controlled to operate; a first clamp diode with a cathode terminal being connected to a point of interconnection between the first and second switching elements and an anode terminal being connected to a DC intermediate terminal; a second clamp diode with a cathode terminal being connected to the DC intermediate terminal and an anode terminal being connected to the point of interconnection between the first and second switching elements; a first temperature relay that detects an over temperature of the first and second switching elements; and a second temperature relay that detects an over temperature of the third and fourth switching elements, wherein the first to fourth switching elements and the first and second clamp diodes are respectively formed of a wide bandgap semiconductor, the first switching element, the first clamp diode, and the second switching element are arranged tandemly in this order on one side of an element substrate along a flow direction of cooling air, the fourth switching element, the second clamp diode, and the third switching element are arranged tandemly in this order on the other side of the element substrate along the flow direction of the cooling air, the first temperature relay is arranged on an edge side of the element substrate in a near-field region around the first and fourth switching elements, the second temperature relay is arranged on an edge side of the element substrate in a near-field region around the second and third switching elements, and the first to fourth switching elements, the first and second clamp diodes, and the first and second temperature relays are accommodated in one module.

### Advantageous Effects of Invention

According to the present invention, there is an effect that a power semiconductor module preferably used in the three-level power conversion apparatus in which a cooler is simplified can be provided.

### Brief Description of Drawings

FIG. 1 depicts a functional configuration of an outline of a power conversion apparatus according to an embodiment of the present invention.
FIG. 2 depicts a detailed configuration of respective switching elements in a leg for one phase shown in FIG. 1.
FIG. 3 is a pattern diagram schematically depicting an arrangement of four switching elements and two clamp diodes arranged on an element substrate having one cooler mounted thereon.
FIG. 4 depicts a state of a temperature rise in a case of an operation pattern 1 (for example, a regenerative operation).
FIG. 5 depicts a state of a temperature rise in a case of an operation pattern 2 (for example, a power running operation).
FIG. 6 is an explanatory diagram of an arrangement position of an external-element temperature sensor.
FIG. 7 is an explanatory diagram of an arrangement position of an internal-element temperature sensor.
FIG. 8 is an example of a wiring area on an element substrate.
FIG. 9 depicts a main-circuit inductance loop at the time of a specific switching mode.
FIG. 10 depicts a main-circuit inductance loop different from that shown in FIG. 9 at the time of a specific switching mode.
FIG. 11 depicts a main-circuit inductance loop different from those shown in FIGS. 9 and 10 at the time of a specific switching mode.
FIG. 12 depicts a main-circuit inductance loop different from those shown in FIGS. 9, 10, and 11 at the time of a specific switching mode.
FIG. 13 depicts first and second inductance loops in a chip layout diagram according to the embodiment.
FIG. 14 depicts third and fourth inductance loops in the chip layout diagram according to the embodiment.
FIG. 15 depicts first and second inductance loops in a chip layout diagram as a comparative example.
FIG. 16 depicts third and fourth inductance loops in the chip layout diagram as the comparative example.

### Description of Embodiments

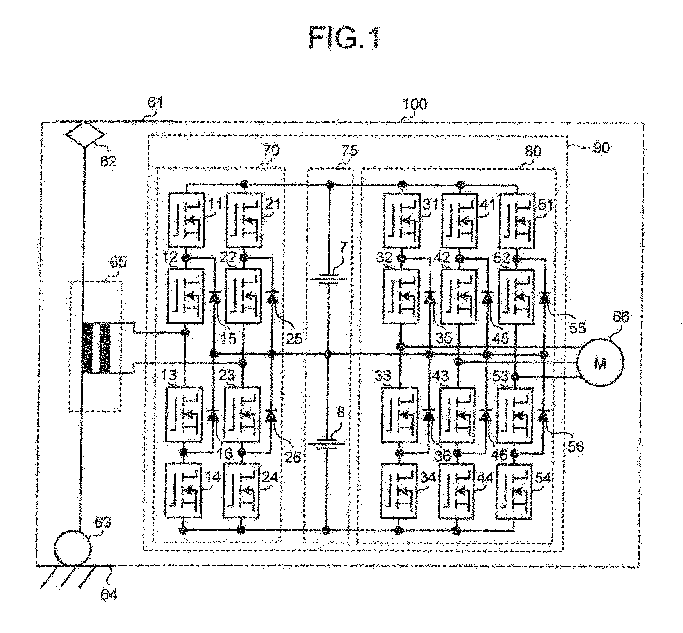

A power conversion apparatus according to an embodiment of the present invention is explained first. FIG. 1 depicts a functional configuration of an outline of the power conversion apparatus according to the embodiment of the present invention, and depicts a configuration example of a power conversion apparatus 90 mounted on a railroad vehicle 100. As shown in FIG. 1, the power conversion apparatus 90 includes a converter circuit 70, a DC voltage circuit 75 having a neutral point, and an inverter circuit 80. The DC voltage circuit 75 includes capacitors 7 and 8 serially connected. Three potential terminals are formed by each end of the capacitors 7 and 8 and a connection point between the capacitors 7 and 8. The converter circuit 70 and the inverter circuit 80 operate as a three-level power conversion apparatus.

The railroad vehicle 100 has mounted thereon a transformer 65 arranged on an input end side of the power conversion apparatus 90 and connected to the converter circuit 70, and a motor 66 arranged on an output end side of the power conversion apparatus 90 and connected to the inverter circuit 80, to drive the vehicle upon reception of a power supply from the power conversion apparatus 90. An induction motor or a synchronous motor is suitable as the motor 66.

One end of a primary winding of the transformer 65 is connected to an overhead line 61 via a power collector 62, and the other end is connected to a rail 64, which is a ground potential, via wheels 63. Power supplied from the overhead line 61 is input to the primary winding of the transformer 65 via the power collector 62, and power generated in a secondary winding of the transformer 65 is input to the converter circuit 70.

The converter circuit 70 includes a U-phase positive-side arm formed of switching elements 11 and 12, and a clamp diode 15, a U-phase negative-side arm formed of switching elements 13 and 14 and a clamp diode 16, a V-phase positive-side arm formed of switching elements 21 and 22 and a clamp diode 25, and a V-phase negative-side arm formed of switching elements 23 and 24 and a clamp diode 26.

The switching elements 11, 12, 13, and 14 are serially connected in this order, and a point of interconnection between the switching elements 12 and 13 is connected to one end of the transformer 65. A cathode terminal of the clamp diode 15 is connected to a point of interconnection between the switching elements 11 and 12, and an anode terminal of the clamp diode 15 is connected to a connection point between the capacitors 7 and 8, which is the neutral point of the DC voltage circuit 75, or an end having the same potential as the connection point.

The negative-side arm has the same configuration and an anode terminal of the clamp diode 16 is connected to a point of interconnection between the switching elements 13 and 14, and a cathode terminal thereof is connected to the neutral point of the DC voltage circuit 75 (the connection point between the capacitors 7 and 8 or the end having the same potential as the connection point, which is also the anode terminal of the clamp diode 15).

The U-phase positive-side arm formed of the switching elements 11 and 12 and the clamp diode 15 and the U-phase negative-side arm formed of the switching elements 13 and 14 and the clamp diode 16 constitute a serially connected circuit (a leg). This configuration is same in the V-phase positive-side arm and the V-phase negative-side arm, and a single-phase bridge circuit having two sets of legs (for the U phase and the V phase) is formed in the converter circuit 70.

The converter circuit 70 PWM-controls the switching elements 11 to 14 and the switching elements 21 to 24 to convert an input alternate current (AC) voltage to a desired DC voltage, and outputs the DC voltage to the DC voltage circuit 75. Because the PWM control with respect to the converter circuit 70 is well-known, explanation thereof will be omitted here.

The inverter circuit 80, which receives a DC voltage respectively from the capacitors 7 and 8, converts each DV voltage to the AC voltage having an arbitrary voltage and an arbitrary frequency, and outputs the AC voltage, is connected to an output terminal of the DC voltage circuit 75.

The leg configuration of the inverter circuit 80 has the same configuration as that of the converter circuit 70, and a different point is the number of phases in the leg. That is, the inverter circuit 80 includes a U-phase positive-side arm formed of switching elements 31 and 32 and a clamp diode 35, a U-phase negative-side arm formed of switching elements 33 and 34 and a clamp diode 36, a V-phase positive-side arm formed of switching elements 41 and 42 and a clamp diode 45, a V-phase negative-side arm formed of switching elements 43 and 44 and a clamp diode 46, a W-phase positive-side arm formed of switching elements 51 and 52 and a clamp diode 55, and a V-phase negative-side arm formed of switching elements 53 and 54 and a clamp diode 56. A three-phase bridge circuit having three sets of legs (for the U phase, the V phase, and the W phase) is formed in the inverter circuit 80.

The inverter circuit 80 PWM-controls the switching elements 31 to 34, the switching elements 41 to 44, and the switching elements 51 to 54 to convert the input DC voltage to a desired AC voltage, and outputs the AC voltage to the motor 66. Because the PWM control with respect to the inverter circuit 80 is well-known, explanation thereof will be omitted here.

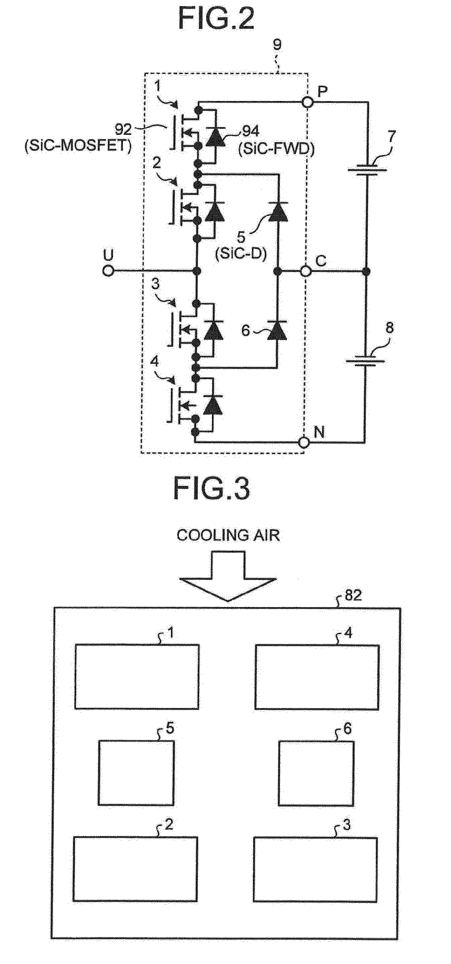

FIG. 2 depicts a detailed configuration of the respective switching elements in a leg for one phase shown in FIG. 1. As shown in FIG. 2, as the switching elements constituting a leg 9, for example in a switching element 1, an SiC-based SiC-MOSFET 92 and an SiC-based SiC-FWD (Fly Wheel Diode) 94 are connected in an anti-parallel configuration. A clamp diode 5 is also an SiC-based diode (SiC-D). The same holds true for other switching elements 2 to 4 and a clamp diode 6, and a leg for one phase is formed of four switching elements and two clamp diodes constituted in this manner.

The leg 9 shown in FIG. 2 is also a constituent unit as a power module, and the switching elements 1 to 4 and the clamp diodes 5 and 6 are accommodated, together with a temperature sensor described later, in one module and packaged. At this time, a terminal pulled out from the connection point between the switching elements 2 and 3 forms a U terminal, which is an AC terminal, a terminal pulled from a drain terminal of the switching element 1 forms a P terminal (high-potential-side DC terminal) connected to a high potential side of the DC voltage circuit, a terminal pulled out from a source terminal of the switching element 4 forms an N terminal (low-potential-side DC terminal) connected to a low potential side of the DC voltage circuit, and a terminal pulled out from the connection point between the clamp diodes 5 and 6 forms a C terminal (DC intermediate terminal) connected to the neutral point of the DC voltage circuit. Although not shown in FIG. 2, output terminals of the two temperature sensors described later are also pulled out from the module, and constitute the terminals of the module together with these terminals.

FIG. 3 is a pattern diagram schematically depicting an arrangement of four switching elements and two clamp diodes arranged on an element substrate 82 having one cooler mounted thereon. Reference signs of the respective switching elements and those of the respective clamp diodes correspond to reference signs shown in FIG. 2.

Cooling air for cooling is shown in FIG. 3. The first switching element, the first clamp diode, and the second switching element are arranged tandemly in this order on one side of the element substrate 82 along a flow direction of the cooling air. The fourth switching element, the second clamp diode, and the third switching element are arranged tandemly in this order on the other side of the element substrate 82 along the flow direction of the cooling air. The switching elements 1 and 4 are arranged upwind relative to the flow direction of the cooling air, and the switching elements 2 and 3 are arranged downwind. However, these arrangement relations can be inverted due to the reason described later. That is, the switching elements 1 and 4 can be arranged on the downwind side of the cooling air and the switching elements 2 and 3 can be arranged on the upwind side of the cooling air.

A characteristic feature in the element arrangement shown in FIG. 3 is that, as can be understood from a comparison with FIG. 2, the circuit configuration and the element arrangement are different from those shown in FIG. 2. The reason why such an element arrangement is used is explained later.

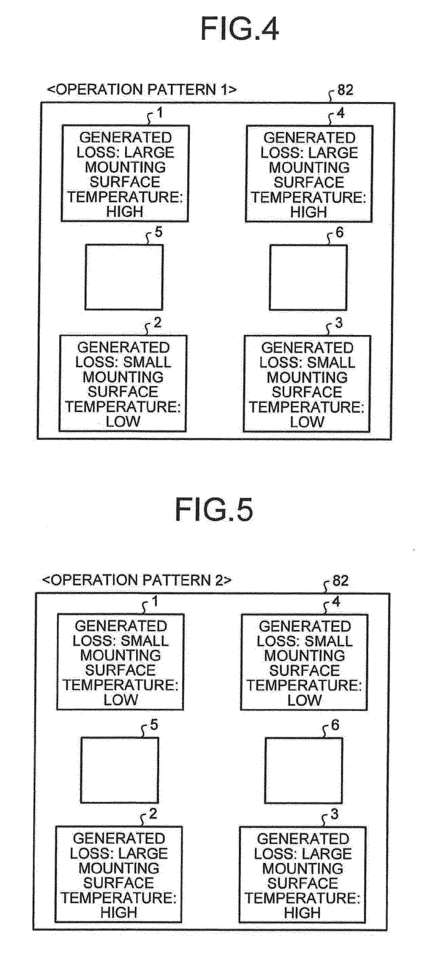

FIGS. 4 and 5 depict a state of a temperature rise due to an operation pattern assumed when the power conversion apparatus according to the present embodiment is used for, for example, a railroad vehicle. For example, FIG. 4 depicts a state of a temperature rise in a case of an operation pattern 1 (for example, a regenerative operation), and FIG. 5 depicts a state of a temperature rise in a case of an operation pattern 2 (for example, a power running operation). These element substrates 82 respectively exemplify one of the element substrates to be mounted on the inverter circuit 80, among the element substrates mounted on the converter circuit 70 and the inverter circuit 80 to constitute one leg.

In FIG. 4, in the operation pattern 1, the generated loss of the switching elements 1 and 4 is large, and the generated loss of the switching elements 2 and 3 is small. That is, switching elements arranged outside in the leg among the four switching elements constituting one leg (hereinafter, "external elements") have a generated loss that is larger than that of switching elements arranged inside in the leg (hereinafter, "internal elements"). Accordingly, the temperature in a portion where the respective switching elements are mounted (hereinafter, "mounting surface temperature") increases in the external elements than in the internal elements.

Meanwhile, in the operation pattern 2, as shown in FIG. 5, the generated loss of the switching elements 2 and 3 is large, and the generated loss of the switching elements 1 and 4 is small. That is, it is opposite to the case in FIG. 4, and the generated loss of the internal elements is larger than that of the external elements, and the mounting surface temperature of the internal elements is higher than that of the external elements.

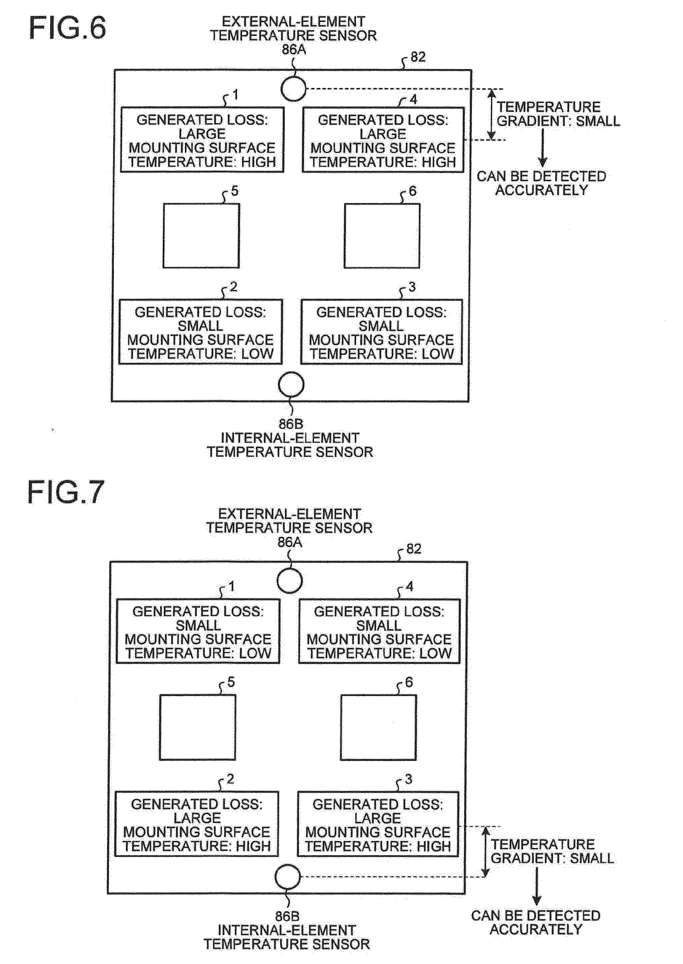

Therefore, in the power conversion apparatus according to the present embodiment, as shown in FIGS. 6 and 7, one temperature sensor (an external-element temperature sensor 86A) is arranged in a near-field region of the switching elements 1 and 4, which are the external elements, and the other temperature sensor (an internal-element temperature sensor 86B) is arranged in a near-field region of the switching elements 2 and 3, which are the internal elements. If the external-element temperature sensor 86A is arranged at a position substantially equidistant from the switching elements 1 and 4, a temperature gradient from the switching element 1 and a temperature gradient from the switching element 4 at this position become substantially the same. Accordingly, the temperature of these switching elements 1 and 4 can be accurately detected. The same holds true for the internal-element temperature sensor 86B, and by arranging the internal-element temperature sensor 86B at a position substantially equidistant from the switching elements 2 and 3, it is enabled to detect the temperature of the switching elements 2 and 3 accurately.

In the case of the power conversion apparatus according to the present embodiment, as described above, it is taken into consideration that the three-level power conversion apparatus is used for a railroad vehicle, an SiC semiconductor is used as the respective switching elements, and a simple radiation mechanism such as a heat sink is adopted. Therefore, the operation of each switching element is different depending on the operation mode unique to the railroad vehicle, and the temperature gradient on the element substrate in the entire element substrate increases.

However, in the case of the operation pattern 1, as shown in FIG. 6, the temperature rise of the switching elements 1 and 4 (that is, the external elements) having a large generated loss and a high mounting surface temperature can be accurately detected by the external-element temperature sensor 86A. It is because the external-element temperature sensor 86A is arranged near the switching elements 1 and 4, and thus the temperature gradient between the external-element temperature sensor 86A and the switching elements 1 and 4 is small.

Meanwhile, in the case of the operation pattern 2, as shown in FIG. 7, the temperature rise of the switching elements 2 and 3 (that is, the internal elements) having a large generated loss and a high mounting surface temperature can be accurately detected by the internal-element temperature sensor 86B. Because the internal-element temperature sensor 86B is arranged near the switching elements 2 and 3, the temperature gradient between the internal-element temperature sensor 86B and the switching elements 2 and 3 is small, and the temperature rise of the switching elements 2 and 3 can be accurately detected as in the operation pattern 1. The over temperature control performed by the external-element temperature sensor 86A and the internal-element temperature sensor 86B can be performed by, for example, using a logical sum output of the both sensors. That is, when at least one of the external-element temperature sensor 86A and the internal-element temperature sensor 86B detects an over temperature, the over temperature control of the entire module can be performed.

The external-element temperature sensor 86A and the internal-element temperature sensor 86B are explained next. As the temperature sensor, there are a sensor that opens and closes a contact point upon detection that the temperature becomes a set value, such as a temperature relay, and a sensor that can detect the temperature itself such as a thermistor. The temperature sensor assumed in the present embodiment is the former type. The set value set in the external-element temperature sensor 86A and the internal-element temperature sensor 86B is set, taking into consideration the temperature gradient generated between the switching elements to be detected and a sensor position. However, in the power conversion apparatus according to the present embodiment, because the respective temperature sensors are arranged at a position where the temperature gradient generated between the switching elements to be detected and the sensor becomes small, the probability that the power conversion apparatus operates at a temperature far from a desired temperature value is extremely low.

The respective set values of the external-element temperature sensor 86A and the internal-element temperature sensor 86B do not need to be the same, and generally these set values are different. These set values can be determined, taking into consideration the strength and direction of the cooling air, a temperature rise pattern of the switching elements according to the operation mode of the power conversion apparatus, and the like. In this sense, any switching elements of the switching elements 1 and 4 and the switching elements 2 and 3 can be positioned on the upwind side of the cooling air.

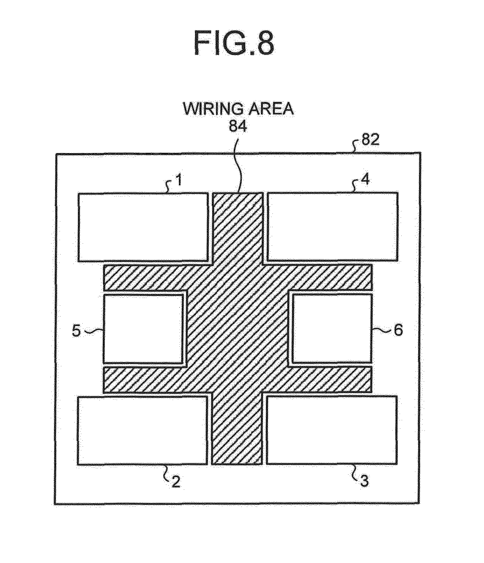

FIG. 8 is an example of a wiring area on the element substrate 82. In FIG. 8, in a wiring area 84 indicated by hatching, a connection wire between the switching elements and a connection wire between the switching elements and the clamp diodes are arranged. Therefore, in manufacturing, it is difficult to arrange the temperature sensor in the wiring area 84. In FIGS. 6 and 7, due to this reason, the external-element temperature sensor 86A is arranged on the edge side of the element substrate 82, in the near-field region around the external elements (the switching elements 1 and 4). The same holds true for the internal-element temperature sensor 86B, and the internal-element temperature sensor 86B is arranged on the edge side of the element substrate 82 in the near-field region around the internal elements (the switching elements 2 and 3).

With reference to FIG. 8, because the area on the left side (the edge side) of the clamp diode 5 and the area on the right side (the edge side) of the clamp diode 6 are not included in the wiring area, it can be considered that the temperature sensor is arranged in these areas. However, in the operation mode of the power conversion apparatus shown in FIGS. 4 and 5, it is not desired because the mounting surface temperature of the switching elements 1 and 2 are different. For example, if the temperature sensor is arranged at a position substantially equidistant from the switching elements 1 and 2 (the area on the left side of the clamp diode 5), because the temperature around a mean value between the switching elements 1 and 2 is detected, it is difficult to estimate the mounting surface temperature of the switching elements 1 and 2 accurately. However, when the mounting surface temperature of the switching elements 1 and 2 simultaneously increases/decreases, the area becomes an area suitable for arranging the temperature sensor.

As a point to be noted in the case of using the SiC semiconductor, there has been explained a feature that, as compared to conventional cases, the amount of heat generation becomes extremely larger in an SiC semiconductor that can perform a high-temperature operation. Meanwhile, a feature such that an element operation in the SiC semiconductor is performed at a speed higher than that in an Si semiconductor is also unignorable. When the switching elements are serially connected and operated as in the three-level power conversion apparatus, it has been pointed out that a voltage exceeding a rated voltage is applied to a specific switching element because of a surge voltage generated due to a main circuit inductance (L) and a change rate of an electric current (di/dt), and an element breakage may be caused, at the time of turning off the switching elements. Accordingly, when the SiC semiconductor is used as the switching elements of the three-level power conversion apparatus, the main circuit inductance needs to be reduced as compared to other power conversion apparatuses.

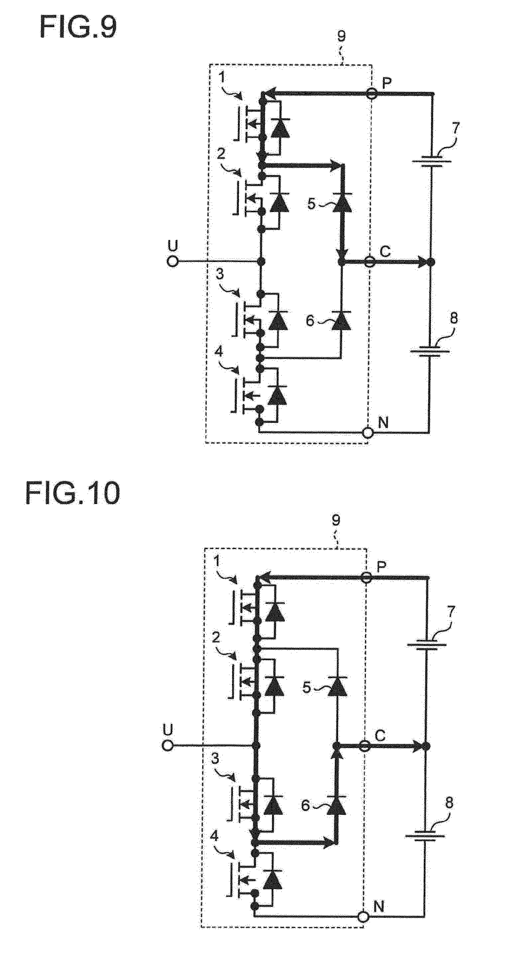

FIGS. 9 to 12 are explanatory diagrams of an influence of the main circuit inductance, and depict a main-circuit inductance loop in a three level inverter.

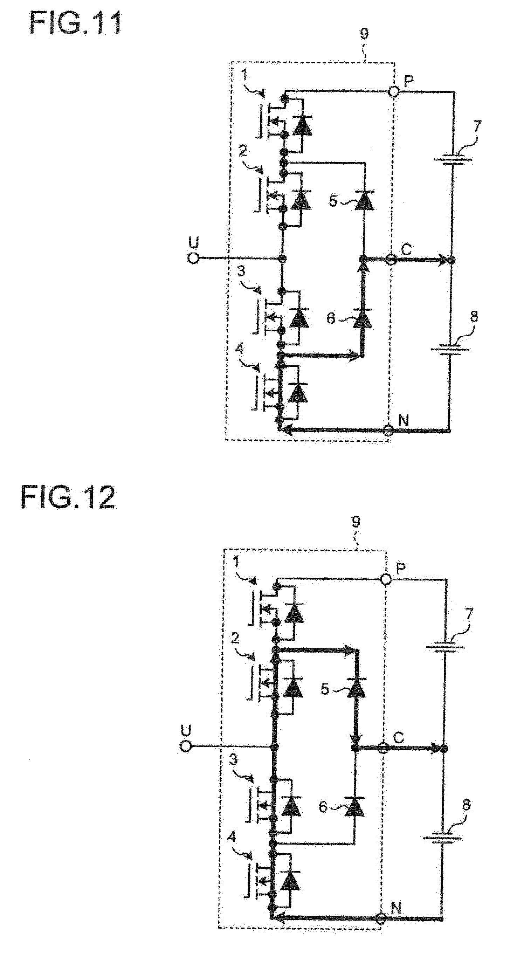

FIG. 9 depicts a first inductance loop passing through the switching element 1 and the clamp diode 5. Similarly, FIG. 10 depicts a second inductance loop passing through the switching elements 1, 2, and 3, and the clamp diode 6, FIG. 11 depicts a third inductance loop passing through the switching elements 4 and the clamp diode 6, and FIG. 12 depicts a fourth inductance loop passing through the switching elements 4, 3, and 2, and the clamp diode 5. The first to fourth inductance loops respectively show a generating path of a back electromotive force (L·di/dt) at the time of a specific switching mode, and do not show an electric current path at the time of a specific switching mode.

A relation between the inductance loops shown in FIGS. 9 to 12 and a chip arrangement of the respective switching elements and clamp diodes according to the present embodiment is explained next.

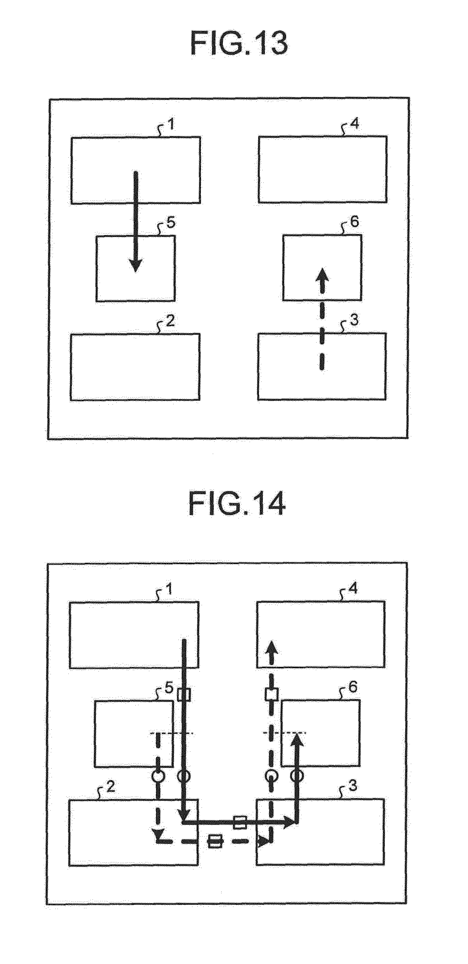

FIG. 13 depicts the first and second inductance loops in a chip layout diagram according to the present embodiment. In FIG. 13, an arrow shown by a thick solid line denotes a route between chips according to the first inductance loop, and an arrow shown by a thick broken line denotes a route between chips according to the second inductance loop. Because inductance components in the respective inductance loops are proportional to a loop length, it is understood that an L component in these first and second inductance loops is set to be a minimum value between the chips.

FIG. 14 depicts the third and fourth inductance loops in the chip layout diagram according to the present embodiment. In FIG. 14, an arrow shown by a thick solid line denotes a route between chips according to the third inductance loop, and an arrow shown by a thick broken line denotes a route between chips according to the fourth inductance loop. In the third inductance loop shown by the thick solid line, the loop length between the chips in this loop is longer than the loop length between the chips in the first inductance loop shown in FIG. 13. However, a part shown by "o" is a part to be folded, and the inductance components in these parts are canceled. Accordingly, the inductance component in the third inductance loop substantially becomes only a part shown by "□", and it is understood that the L component in the third inductance loop is set to be as small as possible. This effect is the same in the fourth inductance loop, and it is understood that the L component in the fourth inductance loop is set to be as small as possible.

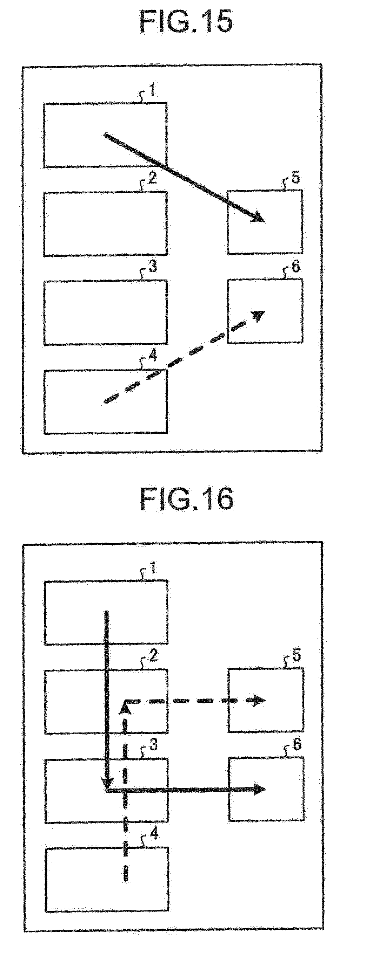

FIGS. 15 and 16 are chip layout diagrams shown as comparative examples, in which four switching elements and two clamp diodes constituting a leg are arranged so as to be visually same as the circuit diagram shown in FIG. 2 and the like.

In FIG. 15, an arrow shown by a thick solid line denotes a route between chips according to the first inductance loop, and an arrow shown by a thick broken line denotes a route between chips according to the second inductance loop. As can be understood from a comparison with FIG. 13, the loop length between chips in the first and second inductance loops shown in FIG. 15 is longer. Accordingly, it is understood that the L component in the first and second inductance loops of the present embodiment is smaller.

In FIG. 16, an arrow shown by a thick solid line denotes a route between chips according to the third inductance loop, and an arrow shown by a thick broken line denotes a route between chips according to the fourth inductance loop. In the case of FIG. 16, in the respective inductance loops, there is no folded part. Accordingly, as can be understood from the comparison with FIG. 14, the loop length in the present embodiment is shorter in the comparison of the loop length excluding the folded part, and the L component in the third and fourth inductance loops is smaller in the present embodiment.

As described above, according to the power conversion apparatus of the present embodiment, the switching elements 1 to 4 and the clamp diodes 5 and 6 are formed of the wide bandgap semiconductor, the switching element 1, the clamp diode 5, and the switching element 2 are arranged tandemly in this order on one side of the element substrate 82 along the flow direction of the cooling air, and the switching element 4, the clamp diode 6, and the switching element 3 are arranged tandemly in this order on the other side of the element substrate 82 along the flow direction of the cooling air. Furthermore, the external-element temperature sensor 86A is arranged on the edge side of the element substrate 82 in the near-field region around the switching elements 1 and 4, the internal-element temperature sensor 86B is arranged on the edge of the element substrate 82 in the near-field region around the switching elements 2 and 3, and the switching elements 1 to 4, the clamp diodes 5 and 6, the external-element temperature sensor 86A, and the internal-element temperature sensor 86B are accommodated in one module. Accordingly, the power semiconductor module preferably used in the three-level power conversion apparatus in which the cooler is simplified can be acquired.

FIGS. 4 and 5 respectively depict a state of a temperature rise in the element substrate 82 of one leg mounted on the inverter circuit 80, and the temperature rise in the element substrate 82 mounted on the converter circuit 70 is in a pattern opposite to the one in the inverter circuit 80. That is, when the temperature rise in the element substrate 82 mounted on the inverter circuit 80 is as shown in FIG. 4, the temperature rise in the element substrate 82 mounted on the converter circuit 70 becomes a state as shown in FIG. 5. On the contrary, when the temperature rise in the element substrate 82 mounted on the inverter circuit 80 is as shown in FIG. 5, the temperature rise in the element substrate 82 mounted on the converter circuit 70 becomes a state as shown in FIG. 4. Accordingly, a method of the present embodiment can be applied to both the inverter circuit and the converter circuit without requiring distinguishing of these circuits.

In the present embodiment, because an SiC-MOSFET is used as the switching element, and an SiC-FWD is used as the diode (FWD) connected to the switching elements in an anti-parallel configuration, the thickness of chips can be reduced and the size of the chips can be reduced.

In the case of the SiC-FWD, because a turn-on voltage can be reduced, there is also an effect that the recovery loss can be considerably reduced. As the FWD, for example, when an SiC-based schottky barrier diode (SiC-SBD) is used, the recovery loss can be further reduced.

Therefore, when the SiC-MOSFET and the SiC-FWD are used, even if the size of chips is reduced, there is an effect that a loss can be reduced while suppressing a temperature rise.

The SiC semiconductor is an example of a semiconductor referred to as "wide bandgap semiconductor", and other than the SiC semiconductor, a semiconductor formed by using a gallium nitride material or diamond also belongs to the type of the wide bandgap semiconductor. Therefore, a configuration using a wide bandgap semiconductor other than an SiC semiconductor is also included in the scope of the present invention.

The configuration described in the above embodiment is only an example of the configuration of the present invention, and it is possible to combine the configuration with other publicly-known techniques, and it is needless to mention that the present invention can be configured while modifying it without departing from the scope of the invention, such as omitting a part of the configuration.

Furthermore, in the present embodiment, the contents of the present invention have been explained while taking into consideration a power semiconductor module assumed to be applied to a railroad vehicle, the applicable field of present invention is not limited thereto, and it is needless to mention that the invention can be also applied to various industrial fields.

### Industrial Applicability

As described above, the power semiconductor module according to the present invention is useful for a three-level power conversion apparatus in which a cooler is simplified.

### Reference Signs List

1 to 4, 11 to 14, 21 to 24, 31 to 34, 41 to 44, 51 to 54 switching element
5, 6, 15, 16, 25, 26, 35, 36, 45, 46, 55, 56 clamp diode
7, 8 capacitor
9 leg
61 overhead line
62 power collector
63 wheel
64 rail
65 transformer
66 motor
70 converter circuit
75 DC voltage circuit
80 inverter circuit
82 element substrate
84 wiring area
86A external-element temperature sensor
86B internal-element temperature sensor
90 power conversion apparatus
100 railroad vehicle

## Claims

1. A power semiconductor module that is applied to a three-level power conversion apparatus for a railroad vehicle, the power semiconductor module comprising:
first and second switching elements that are connected serially in this order between a high-potential-side DC terminal and an AC terminal and on-off controlled to operate;
third and fourth switching elements that are connected serially in this order between the AC terminal and a low-potential-side DC terminal and on-off controlled to operate;
a first clamp diode with a cathode terminal being connected to a point of interconnection between the first and second switching elements and an anode terminal being connected to a DC intermediate terminal;
a second clamp diode with a cathode terminal being connected to the DC intermediate terminal and an anode terminal being connected to the point of interconnection between the first and second switching elements;
a first temperature relay that detects an over temperature of the first and second switching elements; and
a second temperature relay that detects an over temperature of the third and fourth switching elements, wherein
the first to fourth switching elements and the first and second clamp diodes are respectively formed of a wide bandgap semiconductor,
the first switching element, the first clamp diode, and the second switching element are arranged tandemly in this order on one side of an element substrate along a flow direction of cooling air,
the fourth switching element, the second clamp diode, and the third switching element are arranged tandemly in this order on the other side of the element substrate along the flow direction of the cooling air,
the first temperature relay is arranged on an edge side of the element substrate in a near-field region around the first and fourth switching elements,
the second temperature relay is arranged on an edge side of the element substrate in a near-field region around the second and third switching elements, and
the first to fourth switching elements, the first and second clamp diodes, and the first and second temperature relays are accommodated in one module.

2. The power semiconductor module according to claim 1, wherein
the first temperature relay is arranged at a position substantially equidistant from the first switching element and the fourth switching element, and
the second temperature relay is arranged at a position substantially equidistant from the second switching element and the third switching element.

3. The power semiconductor module according to claim 1 or 2, wherein the wide bandgap semiconductor is a semiconductor formed by using silicon carbide, a gallium nitride material, or diamond.

4. A power conversion apparatus comprising plural sets of legs, each of which including:
first and second switching elements that are connected serially in this order between a high-potential-side DC terminal and an AC terminal and on-off controlled to operate,
third and fourth switching elements that are connected serially in this order between the AC output terminal and a low-potential-side DC terminal and on-off controlled to operate,
a first clamp diode with a cathode terminal being connected to a point of interconnection between the first and second switching elements and an anode terminal being connected to a DC intermediate terminal,
a second clamp diode with a cathode terminal being connected to the DC intermediate terminal and an anode terminal being connected to the point of interconnection between the first and second switching elements,
a first temperature relay that detects an over temperature of the first and second switching elements, and
a second temperature relay that detects an over temperature of the third and fourth switching elements, wherein
the first to fourth switching elements and the first and second clamp diodes are respectively formed of a wide bandgap semiconductor,
the first switching element, the first clamp diode, and the second switching element are arranged tandemly in this order on one side of an element substrate along a flow direction of cooling air,
the fourth switching element, the second clamp diode, and the third switching element are arranged tandemly in this order on the other side of the element substrate along the flow direction of cooling air,
the first temperature relay is arranged on an edge side of the element substrate in a near-field region around the first and fourth switching elements,
the second temperature relay is arranged on an edge side of the element substrate in a near-field region around the second and third switching elements, and
the first to fourth switching elements, the first and second clamp diodes, and the first and second temperature relays are accommodated in one module for each leg.

5. A railroad vehicle comprising a power conversion apparatus that converts an input DC voltage or an AC voltage to a desired AC voltage and outputs the AC voltage, and a motor that drives a vehicle upon reception of a power supply from the power conversion apparatus, wherein
the power conversion apparatus includes plural sets of legs, each of which including:
first and second switching elements that are connected serially in this order between a high-potential-side DC terminal and an AC terminal and on-off controlled to operate,
third and fourth switching elements that are connected serially in this order between the AC output terminal and a low-potential-side DC terminal and on-off controlled to operate,
a first clamp diode with a cathode terminal being connected to a point of interconnection between the first and second switching elements and an anode terminal being connected to a DC intermediate terminal,
a second clamp diode with a cathode terminal being connected to the DC intermediate terminal and an anode terminal being connected to the point of interconnection between the first and second switching elements,
a first temperature relay that detects an over temperature of the first and second switching elements, and
a second temperature relay that detects an over temperature of the third and fourth switching elements, and wherein
the first to fourth switching elements and the first and second clamp diodes are respectively formed of a wide bandgap semiconductor,
the first switching element, the first clamp diode, and the second switching element are arranged tandemly in this order on one side of an element substrate along a flow direction of cooling air,
the fourth switching element, the second clamp diode, and the third switching element are arranged tandemly in this order on the other side of the element substrate along the flow direction of cooling air,
the first temperature relay is arranged on an edge side of the element substrate in a near-field region around the first and fourth switching elements,
the second temperature relay is arranged on an edge side of the element substrate in a near-field region around the second and third switching elements, and
the first to fourth switching elements, the first and second clamp diodes, and the first and second temperature relays are accommodated in one module for each leg.
